# EUROPÄISCHE PATENTSCHRIFT

(11) **EP 3 279 681 B1**
(45) Veröffentlichungstag und Bekanntmachung des Hinweises auf die Patenterteilung: **12.12.2018**
(21) Anmeldenummer: 17184642.1
(22) Anmeldetag: 03.08.2017
(51) Int. Cl.: G01R 33/36, G01R 33/20

(54) **HOCHFREQUENZ-INTERFACE-SCHALTKREIS, HOCHFREQUENZSYSTEM UND MAGNETRESONANZAPPARATUR MIT EINEM HOCHFREQUENZ-INTERFACE-SCHALTKREIS**
HIGH-FREQUENCY INTERFACE CIRCUIT, HIGH FREQUENCY SYSTEM AND MAGNETIC RESONANCE DEVICE WITH A HIGH-FREQUENCY INTERFACE CIRCUIT
CIRCUIT D'INTERFACE HAUTE FRÉQUENCE, SYSTÈME HAUTE FRÉQUENCE ET APPAREIL DE RÉSONANCE MAGNÉTIQUE POURVU D'UN CIRCUIT D'INTERFACE HAUTE FRÉQUENCE

(30) Priorität: 04.08.2016 DE 102016214441
(43) Veröffentlichungstag der Anmeldung: 07.02.2018
(73) Patentinhaber: Bruker BioSpin GmbH, 76287 Rheinstetten (DE)
(72) Erfinder: Maixner, Michael, 76467 Bietigheim (DE)
(74) Vertreter: Kohler Schmid Möbus Patentanwälte

(56) Entgegenhaltungen:
- JP-A- 2008 194 180
- US-A1- 2010 166 279
- US-A1- 2011 316 540
- US-B1- 6 198 288

## Beschreibung

### Hintergrund der Erfindung

Die Erfindung betrifft einen Hochfrequenz-Interface-Schaltkreis zum Leiten von Sendesignalen eines HF-Generators über einen Eingang des Hochfrequenz-Interface-Schaltkreises zu einem Anschluss für eine HF-Anordnung in einem Sendebetrieb und zum Leiten von Empfangssignalen von dem Anschluss der HF-Anordnung über einen Ausgang des Hochfrequenz-Interface-Schaltkreises zu einem Empfangssystem in einem Empfangsbetrieb, wobei der Interface-Schaltkreis Folgendes umfasst: einen Sendepfad, der den Eingang des Hochfrequenz-Interface-Schaltkreises mit dem Anschluss zum Anschließen der HF-Anordnung verbindet; einen Empfangspfad, der den Anschluss zum Anschließen der HF-Anordnung mit dem Ausgang des Hochfrequenz-Interface-Schaltkreises verbindet, wobei der Empfangspfad einen ersten Schaltkreis umfasst, wobei der erste Schaltkreis mindestens ein erstes Schaltelement umfasst, welches im Sendebetrieb elektrisch leitend und im Empfangsbetrieb elektrisch isolierend ist, wobei im Sendebetrieb der erste Schaltkreis zwei in Serie geschaltete Parallelresonanzkreise bildet, die den Ausgang des Hochfrequenz-Interface-Schaltkreises von dem Anschluss zum Anschließen der HF-Anordnung isolieren.

Ein derartiger Interface-Schaltkreis ist bekannt aus US 6 198 288 B1.

Bei Magnetresonanzverfahren wird ein zu untersuchendes Objekt mit Sendesignalen bestrahlt, die von einem HF-Generator erzeugt werden. Die vom Objekt abgegebenen hochfrequenten MR-Signale werden detektiert. Beides erfolgt mit Hilfe einer Sende-Empfangs-Antenne (Probenkopf, Resonator). Die Sendesignale werden über einen Hochfrequenz-Interface-Schaltkreis vom HF-Generator zur Sende-Empfangs-Antenne und die Empfangssignale von dieser zur Empfangsanordnung geleitet. Da die Leistung der gesendeten Sendesignale im Vergleich zu der der empfangenen MR-Signalen sehr hoch ist, ist es bekannt, im Empfangspfad des Interface-Schaltkreises zwei Sperrkreise vorzusehen, welche die Sendesignale stark dämpfen, um das Empfangssystem nicht zu schädigen, wie bspw. in US 6 198 288 B1 beschrieben. Die Frequenz der Sendesignale ist abhängig von der Art der Kerne, die angeregt werden sollen.

Problematisch bei dem aus US 6 198 288 B1 bekannten Interface-Schaltkreis ist jedoch, dass einerseits eine Vielzahl an Bauteilen benötigt wird und andererseits nur ein kleiner Frequenzbereich durch die Filterschaltung im Empfangspfad gelangt.

JP2008/194180 definiert im Sendebetrieb zwei in Serie geschaltete Parallelresonanzkreise ; im Empfangsbetrieb zwei in parallel geschaltete Serienresonanzkreise . Der Effekt ist eine Verbesserung der Isolierung.

### Aufgabe der Erfindung

Es ist Aufgabe der Erfindung, einen Interface-Schaltkreis sowie ein Hochfrequenzsystem und eine Magnetresonanzapparatur zur Verfügung zu stellen, die mit einem einfachen und kostengünstigen Aufbau innerhalb einer größeren Bandbreite eine verlustarme Sende-Empfangsumschaltung ermöglichen.

### Beschreibung der Erfindung

Diese Aufgabe wird erfindungsgemäß dadurch gelöst, dass im Empfangsbetrieb der erste Schaltkreis zwei parallel geschaltete Serienresonanzkreise umfasst.

Im Empfangsbetrieb befindet sich das erste Schaltelement im nicht leitenden Zustand (offen) und es wird durch die parallel geschalteten Serienresonanzkreise eine niedrige Impedanz in einem großen Frequenzbereich erzeugt. Dadurch wird ein breitbandiger und verlustarmer Empfang realisiert. Im Sendebetrieb befindet sich das erste Schaltelement im leitenden Zustand (geschlossen) und es wird durch zwei hochohmige, in Serie geschaltete Parallelresonanzkreise eine hohe Impedanz für die Sendeleistung (Leistung des vom HF-Generator erzeugten HF-Signals) des in Reihe liegenden HF-Empfangssystems bereitgestellt. Dadurch wird sichergestellt, dass die Leistung des HF-Generators im Sendefall nahezu ungehindert an der HF-Anordnung ankommt und das Empfangssystem vor einer Zerstörung durch die Sendeleistung geschützt wird.

Bei der vorliegenden Erfindung sind also im Empfangsbetrieb zwei parallel liegende Signalwege vorhanden. Dadurch kann eine Bandbreite erreicht werden, die ein Frequenzverhältnis von der tiefsten zur höchsten Frequenz, von mehr als Faktor 5 umfasst.

Vorzugsweise umfasst der erste Schaltkreis ein erstes induktives Element, ein zweites induktives Element, ein erstes kapazitives Element und ein zweites kapazitives Element, wobei im Sendefall das zweite kapazitive Element zusammen mit dem ersten induktiven Element und das erste kapazitive Element zusammen mit dem zweiten induktiven Element jeweils einen der beiden Parallelresonanzkreise des ersten Schaltkreises bilden, wobei das erste Schaltelement Teil sowohl des ersten als auch des zweiten Parallelresonanzkreises ist. Im Empfangsfall bilden das zweite kapazitive Element zusammen mit dem zweiten induktiven Element und das erste kapazitive Element zusammen mit dem ersten induktiven Element jeweils einen der beiden Serienresonanzkreise des ersten Schaltkreises.

Bei einer besonders bevorzugten Ausführungsform des erfindungsgemäßen Hochfrequenz-Interface-Schaltkreises umfasst der Empfangspfad ein erdendes zweites Schaltelement, welches im Sendebetrieb elektrisch leitend und im Empfangsbetrieb elektrisch isolierend ist.

Das zweite Schaltelement kann als zusätzlicher Empfängerschutz dienen und ist dazu vorzugsweise im Empfangspfad direkt vor dem Ausgang des Hochfrequenz-Interface-Schaltkreises angeordnet. Das zweite Schaltelement begrenzt dann die Sendeleistung, die die verschiedenen Schaltkreise des Empfangspfades durchlaufen haben könnten, auf einen, für die nachfolgende Empfangsschaltung ungefährlichen Wert.

Bei einer besonders bevorzugten Ausführungsform umfasst der Empfangspfad einen zweiten Schaltkreis, der in Serie zum ersten Schaltkreis geschaltet ist, wobei das zweite Schaltelement Teil des zweiten Schaltkreises ist, und wobei der zweite Schaltkreis im Empfangsbetrieb einen Tiefpass und im Sendebetrieb einen dritten Parallelresonanzkreis bildet. Der zweite Schaltkreis ist hinter dem ersten Schaltkreis angeordnet, also zwischen dem ersten Schaltkreis und dem Ausgang des Hochfrequenz-Interface-Schaltkreises.

Der Parallelresonanzkreis im zweiten Schaltkreis (dritter Parallelresonanzkreis) stellt eine hohe Impedanz gegenüber der Sendeleistung in einem durch die elektrischen Werte von Induktivität und Kapazität bestimmten Frequenzbereich dar, so dass die Impedanz für die Sendeleistung durch die Zusammenschaltung des ersten und zweiten Schaltkreises weiter vergrößert wird. Dies bewirkt, dass für einen weiten Bereich der Sendefrequenzen (Frequenzen der vom HF-Generator erzeugten HF-Signale) die Sendeleistung effektiv und verlustarm vom Empfangssystem ferngehalten wird.

Vorzugsweise umfasst der zweite Schaltkreis ein drittes induktives Element, und ein drittes kapazitives Element, welche zusammen im Sendebetrieb Teil des dritten Parallelresonanzkreises und im Empfangsbetrieb Teil des Tiefpasses sind. Dadurch wird die Bandbreite des Interface-Schaltkreises vergrößert. Die leitende Verbindung zwischen dem zweiten Schaltelement und dem dritten induktiven Element sollte eine Leitungslänge von einem Zehntel der Wellenlänge der maximalen Nutzfrequenz des Interface-Schaltkreises nicht überschreiten.

Bei einer speziellen Ausführungsform des erfindungsgemäßen Hochfrequenz-Interface-Schaltkreises umfasst der zweite Schaltkreis zusätzlich ein viertes kapazitives Element und ein erdendes drittes Schaltelement, welches im Sendebetrieb elektrisch leitend und im Empfangsbetrieb elektrisch isolierend ist, wobei im Sendebetrieb das vierte kapazitive Element Teil des dritten Parallelresonanzkreises ist. Durch das vierte kapazitive Element wird die Bandbreite des erfindungsgemäßen Hochfrequenz-Interface-Schaltkreises vergrößert.

Hinsichtlich der Vergrößerung der Bandbreite ist es darüber hinaus vorteilhaft, wenn der zweite Schaltkreis zusätzlich ein fünftes kapazitives Element umfasst, welches im Empfangsbetrieb Teil des Tiefpasses ist. Das fünfte kapazitive Element wird im Sendebetrieb dadurch deaktiviert, dass durch das dritte Schaltelements eine erdende Verbindung hergestellt wird.

Eine sehr gute Bandbreite im Empfangsbetrieb und eine sehr gute Dämpfung im Sendebetrieb ergeben sich, wenn die Induktivität des dritten induktiven Elementes halb so groß ist wie die Induktivität des ersten induktiven Elementes oder des zweiten induktiven Elementes. Vorzugsweise weisen das erste induktive Element und das zweite induktive Element die gleiche Induktivität auf. Ein induktives Element kann auch mehrere Spulenelemente umfassen. Insbesondere kann man ausnutzten, dass durch das Parallelschalten gleicher induktiver Elemente der halbe induktive Wert entsteht, so dass zur Realisierung der zuvor genannten Konfiguration (Induktivität des dritten induktiven Elementes halb so groß wie die Induktivität des ersten oder zweiten induktiven Elementes) mit nur einer Spulenspezifikation gearbeitet werden kann, was die Anzahl der benötigten unterschiedlichen Bauteile für den Aufbau des Interface-Schaltkreises reduziert.

Der Sendepfad umfasst vorzugsweise einen Eingangs-Isolationsschaltkreis mit einem vierten Schaltelement, welches im Sendebetrieb elektrisch leitend und im Empfangsbetrieb elektrisch isolierend ist.

Vorzugsweise bildet der Eingangsisolations-Schaltkreis im Sendebetrieb ein HF-Filter. Im Empfangsbetrieb befindet sich also das Schaltelement im nicht leitenden Zustand und der Eingangs-Isolationsschaltkreis bietet selektiv eine hohe Impedanz gegenüber Rauschsignalen. Somit wird im Empfangsbetrieb der Sendepfad vom Empfangspfad abgetrennt. Empfangene Signale kommen dann nahezu ungedämpft am Empfangssystem an. Im Sendebetrieb befindet sich das Schaltelement im leitenden Zustand, so dass der Eingangs-Isolationsschaltkreis als HF-Filter fungiert und alle Frequenzen bis zur Grenzfrequenz des HF-Filters weitgehend ohne Abschwächung weiterleitet.

Das HF-Filter umfasst vorzugsweise ein weiteres (viertes) induktives Element, dessen Induktivität halb so groß sein kann wie die Induktivität des ersten induktiven Elementes oder des zweiten induktiven Elementes im Empfangspfad. Außerdem kann das vierte induktive Element (Sendepfad) den gleichen induktiven Wert wie das dritte induktive Element (Empfangspfad) haben.

Bei einer speziellen Ausführungsform des erfindungsgemäßen Interface-Schaltkreises sind alle zuvor genannten induktiven Elementen mit gleichen Spulenelementen (also Spulenelementen mit derselben Induktivität) aufgebaut, wobei für das dritte und das vierte induktive Element jeweils zwei Induktivitäten parallelgeschaltet sind, wodurch eine Halbierung der Induktivität erreicht wird. Hierdurch kann die Anzahl unterschiedlicher Bauteile, und somit der Kostenfaktor reduziert werden, wobei nur ein sehr geringer Verlust an Performance in Kauf genommen werden muss.

Der erfindungsgemäße Interface-Schaltkreis wird vorzugsweise in einer Magnetresonanzapparatur verwendet, kann jedoch auch in anderen technischen Gebieten Anwendung finden, in denen hochenergetische Mehrfrequenzsignale wechselweise gesendet und über eine Antenne empfangen werden (z.B. Mobilfunk).

Die Erfindung betrifft auch ein Hochfrequenz-System mit einem HF-Generator zum Erzeugen von HF-Signalen, einer HF-Anordnung zum Senden und Detektieren von HF-Signalen, ein Empfangssystem zum Verarbeiten der detektierten HF-Signale und einem zuvor beschriebenen Hochfrequenz-Interface-Schaltkreis, wobei der HF-Generator am Eingang des Hochfrequenz-Interface-Schaltkreises, das Empfangssystem am Ausgang und die HF-Anordnung am dafür vorgesehenen Anschluss des Hochfrequenz-Interface-Schaltkreises angeschlossen sind.

Die Erfindung betrifft auch eine Magnetresonanzapparatur mit einer HF-Anordnung zum Anregen von Magnetresonanzen und zum Empfangen von MR-Signalen und mit einem zuvor beschriebenen Hochfrequenz-Interface-Schaltkreis.

Vorzugsweise handelt es sich bei der HF-Anordnung um einen MR-Probenkopf.

Darüber hinaus betrifft die Erfindung die Verwendung eines zuvor beschriebenen Hochfrequenz-Interface-Schaltkreises in einer Magnetresonanzapparatur, insbesondere für Mehrfachresonanz-MR-Messungen. Hierdurch wird ermöglicht, Atomkerne mit unterschiedliche Resonanzfrequenzen mittels ein und derselben Sende-Empfangsschaltung anzuregen und Multikern-Aufnahmen durchzuführen. Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt einen schematischen Aufbau einer erfindungsgemäßen Magnetresonanzapparatur.
- Fig. 2: zeigt ein Schaltbild einer einfachen Ausführungsform des erfindungsgemäßen Hochfrequenz-Interface-Schaltkreises.
- Fig. 3: zeigt ein Schaltbild einer besonders bevorzugten Ausführungsform des erfindungsgemäßen Hochfrequenz-Interface-Schaltkreises.
- Fig. 4: zeigt ein Ersatzschaltbild des erfindungsgemäßen Hochfrequenz-Interface-Schaltkreises aus Fig. 3 im Sendebetrieb.
- Fig. 5: zeigt ein Ersatzschaltbild des erfindungsgemäßen Hochfrequenz-Interface-Schaltkreises aus Fig. 3 im Empfangsbetrieb.
- Fig. 6: zeigt simulierte Durchlasskurven vom Sender zur HF-Anordnung sowie Anpassungskurven für den erfindungsgemäßen Hochfrequenz-InterfaceSchaltkreises aus Fig. 3 im Vergleich zu dem aus US 6 198 288 B1 bekannten Hochfrequenz-Interface-Schaltkreis, wobei dessen Bauteilwerte so gewählt wurden, dass sich eine möglichst große nutzbare Bandbreite ergibt.
- Fig. 7: zeigt simulierte Durchlasskurven von der HF-Anordnung zum Empfangssystem sowie Anpassungskurven für den erfindungsgemäßen Hochfrequenz-Interface-Schaltkreises aus Fig. 3 im Vergleich zu dem aus US 6 198 288 B1 bekannten Hochfrequenz-Interface-Schaltkreis, wobei dessen Bauteilwerte so gewählt wurden, dass sich eine möglichst große nutzbare Bandbreite ergibt.

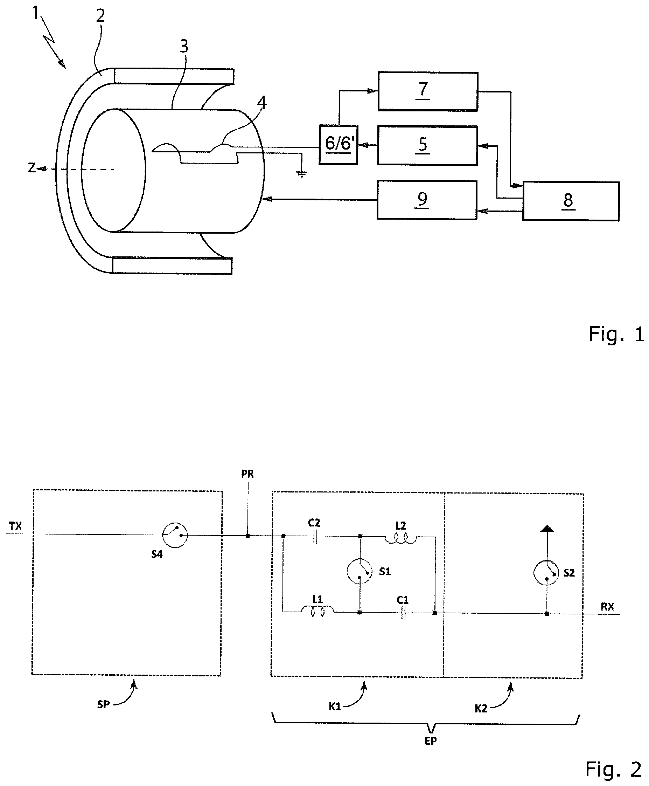

**Fig. 1** zeigt den Aufbau einer erfindungsgemäßen Magnetresonanzapparatur **1** mit einem Hauptmagneten **2** zur Erzeugung eines zeitlich konstanten Hauptmagnetfeldes in Längsrichtung **z** des Hauptmagneten 2, einem Gradientensystem **3** und einer HF-Anordnung **4.** Von einem HF-Generator **5** werden HF-Signale über einen Interface-Schaltkreis **6, 6**' im Sendebetrieb an die HF-Anordnung 4 (hier HF-Sende/Empfangsspule) weitergeleitet, die innerhalb eines Untersuchungsvolumens hochfrequente Anregungspulse erzeugt. Die als HF-Anordnung 4 dienende HF-Sende/Empfangsspule ist hier beispielhaft als Sattelspule für eine MR-Körperspule dargestellt. Der Interface-Schaltkreis 6 leitet im Empfangsbetrieb die von der HF-Anordnung empfangenen MR-Signale an ein Empfangssystem **7** und von diesem an eine Steuereinrichtung **8** weiter. Die Steuereinrichtung 8 dient zum Steuern des HF-Generators 5 sowie zum Steuern von Gradientenverstärkern **9** für das Gradientensystem 3.

Das Grundprinzip des erfindungsgemäßen Interface-Schaltkreises 6 ist in **Fig. 2** gezeigt.

Der Interface-Schaltkreis 6 umfasst einen Eingang **TX,** einen Ausgang **RX,** einen Anschluss **PR** zum Anschließen der HF-Anordnung 4, einen Sendepfad **SP,** der den Eingang TX mit dem Anschluss PR verbindet, und einen Empfangspfad **EP**, der den Anschluss PR mit dem Ausgang **RX** verbindet.

Im Sendebetrieb können so HF-(Sende)Signale vom HF-Generator 5 über den Sendepfad SP des Interface-Schaltkreises 6 zur HF-Anordnung 4 geleitet werden und der Durchlass der HF-Signale zum Empfangssystem kann blockiert werden. Dazu ist im Empfangspfad EP ein erster Schaltkreis **K1** vorgesehen mit einem ersten Schaltelement **S1**, einem ersten und einem zweiten kapazitiven Element **C1, C2** sowie einem ersten und einem zweiten induktiven Element **L1, L2.** Das erste Schaltelement S1 ist mit den beiden induktiven Elementen L1, L2 und den beiden kapazitiven Elementen C1, C2 so verschaltet, dass bei geschlossenem Schaltelement zwei in Serie geschaltete Parallelresonanzkreise vorhanden sind, welche als Sperrkreise fungieren (Sperrkreis 1: L1, C2; Sperrkreis 2: L2, C1). Das erste Schaltelement S1 ist dabei sowohl Teil des ersten als auch des zweiten Parallelresonanzkreises. Bei geöffnetem ersten Schaltelement S1 sind zwei parallel geschaltete Serienresonanzkreise vorhanden (Serienresonanzkreis 1: L1, C1; Serienresonanzkreis 2: L2, C2).

Im Empfangspfad EP ist ein erdendes zweites Schaltelement **S2** angeordnet. Der erste Schaltkreis K1 ist zwischen dem Anschluss für die HF-Anordnung 4 und dem zweiten Schaltelement S2 (also innerhalb des Empfangspfads anschlussseitig) angeordnet.

Darüber hinaus umfasst der Sendepfad SP des erfindungsgemäßen Interface-Schaltkreises 6 ein weiteres Schaltelement S4, mit dem der Sendepfad SP vom Empfangspfad EP abgetrennt werden kann.

Im Sendebetrieb sind die beschriebenen Schaltelemente S1, S2, S4 geschlossen. Das vom HF-Generator 5 erzeugte HF-Signal kann so über den durchgeschalteten Sendepfad SP zur HF-Anordnung 4 gelangen. Die beiden Sperrkreise im ersten Schaltkreis K1 des Empfangspfads EP bewirken eine hohe Impedanz für die Sendeleistung des HF-Generators 5. Zusätzlich bewirkt das geschlossene zweite Schaltelement S2 im Sendebetrieb, dass Sendeleistung, welche die beiden Sperrkreise des ersten Schaltkreises K1 eventuell durchlaufen haben könnte, nach Masse abgeleitet wird (Empfängerschutz).

Im Empfangsbetrieb sind die oben beschriebenen Schaltelemente S1, S2, S4 geöffnet. Der Sendepfad SP ist dann vom Empfangspfad EP getrennt. Die von der HF-Anordnung 4 detektierten HF-Signale (z.B. MR-Signale) werden zu dem Empfangssystem 7 geleitet. Dies wird durch die beiden im Empfangsbetrieb parallel geschalteten Serienresonanzkreise des ersten Schaltkreises K1 im Empfangspfad EP und der durch das zweite Schaltelement S2 unterbrochenen Erdungsleitung in einem großen Frequenzbereich ermöglicht.

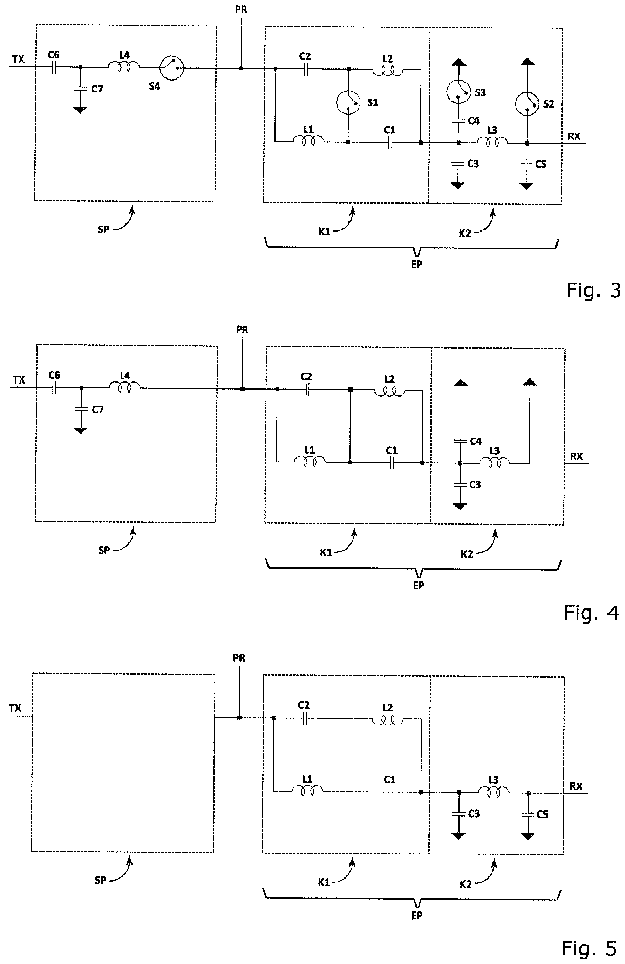

**Fig. 3** zeigt eine optimierte Ausführungsform des erfindungsgemäßen Interface-Schaltkreises 6'.

Der Empfangspfad EP weist hier einen zweiten Schaltkreis **K2** auf, der neben dem erdenden zweiten Schaltelement S2, ein erdendes drittes Schaltelement **S3**, ein drittes induktives Element **L3** sowie weitere kapazitive Elemente (drittes, viertes und fünftes kapazitives Element **C3, C4, C5**) enthält, wobei das dritte und das fünfte kapazitive Element C3, C5 auf Erdpotential liegen. Der ersten Schaltkreis K1 und der zweite Schaltkreis K2 sind in Serie geschalten, wobei der erste Schaltkreis K1 anschlussseitig (zwischen Anschluss PR und zweitem Schaltkreis K2) und der zweite Schaltkreis K2 ausgangsseitig (zwischen ersten Schaltkreis K1 und Ausgang RX) innerhalb des Empfangspfads EP angeordnet sind.

Im Sendepfad SP sind ein weiteres induktives Element (viertes induktives Element **L4**) und zusätzliche kapazitive Elemente **C6, C7** angeordnet, wobei eines der zusätzliche kapazitiven Elemente (hier: C7) auf Erdpotential liegt. Die zusätzlichen kapazitiven Elemente C6, C7 und das weitere induktive Element L4 dienen zur Verbesserung der Anpassung an den Ausgang des HF-Generators 5. Darüber hinaus bildet das weitere induktive Element L4 zusammen mit den zusätzlichen kapazitiven Elementen C6, C7 ein HF-Filter, das HF-Signale aller Frequenzen bis zur Grenzfrequenz weitgehend ohne Abschwächung weiterleitet.

Im Sendebetrieb (alle Schaltelemente S1, S2, S3, S4 sind geschlossen) bilden das dritte induktive Element L3 zusammen mit dem dritten und vierten kapazitiven Element C3, C4 einen dritten Sperrkreis. Ein Ersatzschaltkreis für den Sendebetrieb ist in **Fig. 4** gezeigt. Das HF-Signal gelangt vom HF-Generator 5 über das weitere kapazitive Element C6 und das weitere induktive Element L4 des Sendepfads SP zum Anschluss PR, wo es einerseits zur HF-Anordnung 4 gelangt und andererseits auf die drei hintereinander geschaltete Sperrkreisen des Empfangspfads EP trifft. Beim Einsatz von PIN-Dioden als Schaltelemente kann zwischen dem Anschluss PR und der HF-Anordnung ein kapazitives Element vorgesehen sein, um den für das Durchschalten der PIN-Dioden erforderlichen Schaltstrom nicht über die HF-Anordnung abfließen zu lassen.

Um vom Sendebetrieb in den Empfangsbetrieb zu wechseln, werden die Schaltelemente S1, S2, S3, S4 in einen nicht leitenden Zustand gebracht. Ein Ersatzschaltkreis für den Empfangsbetrieb ist in **Fig. 5** gezeigt. Das dritte induktive Element L3 bildet zusammen mit den beiden auf Erdpotential liegenden dritten und fünften kapazitiven Elementen C3, C5 einen Tiefpassfilter. Das zu empfangende HF-Signal gelangt nun über die zwei parallel geschaltete Serienresonanzkreise des ersten Schaltkreises K1 und dem Tiefpassfilter des zweiten Schaltkreises K2 zum HF-Empfangssystem 7.

Der in Fig. 3 gezeigte Interface-Schaltkreis 6' umfasst im Sendebetrieb also drei in Serie geschaltete Isolationsschaltkreise, die mit der HF-Anordnung 4 verbunden sind. Durch das Vorsehen des dritten Sperrkreises im Empfangspfad EP kann die Sendeleistung des HF-Signals noch effektiver und über einen größeren Frequenzbereich vom Empfangssystem 7 ferngehalten werden als dies im Stand der Technik der Fall ist. Im Empfangsbetrieb bietet der erfindungsgemäße Interface-Schaltkreis 6' aufgrund der zwei parallel geschalteten Serienresonanzkreise in einem großen Frequenzbereich eine niedrige Impedanz gegenüber dem HF-Signal, um die HF-Anordnung 4 verlustarm mit dem Empfangssystem 7 zu verbinden. Der erfindungsgemäße Sende- und Empfangs-Interface-Schaltkreis 6, 6' kann somit Sendesignale mit beliebig vielen ausgewählten Frequenzen bis zu den Grenzfrequenzen des Interface-Schaltkreises 6, 6' vom HF-Generator 5 zur HF-Anordnung 4 leiten, während der Ausgang **RX** des Interface-Schaltkreises 6, 6' zum Empfangssystem 7 isoliert wird, und Empfangssignale mit beliebig vielen Frequenzen bis zu den Grenzfrequenzen des Interface-Schaltkreises 6, 6' von der HF-Anordnung 4 zum Empfangssystem 7 leiten, während der Eingang TX zum HF-Generator 5 isoliert wird.

Die Schaltelemente S1, S2, S3, S4 können beispielsweise durch PIN-Dioden realisiert sein, die zur effizienten Nutzung eines Vorelektrisierungsgleichstroms alle entlang eines Gleichstromweges in Reihe geschaltet sind. In diesem Fall sind nur wenige, für die Hochfrequenzeigenschaften des Interface-Schaltkreises 6, 6' unerhebliche weitere Spulen oder Widerstände und Kondensatoren (nicht gezeigt) nötig, was den Abgleich der Schaltung vereinfacht. Für einen korrekten Betrieb des Schaltkreises können jedoch auch alternative Dioden-Gleichstromansteuerungsschaltkreise verwendet werden. Wird der erfindungsgemäße Interface-Schaltkreis mit Leistungen über ca. 5W und kurzen HF-Impulsen betrieben, so können die Schaltelemente S1, S2, S3, S4 durch antiparallele Schaltdioden realisiert werden. In diesem Fall ist keine weitere Ansteuerung für das Umschalten vom Sendebetrieb auf Empfangsbetrieb nötig, weil die Dioden durch die HF-Leistung selbst in den leitenden Zustand versetzt werden. Die Umschaltzeit wird so sehr kurz (wenige Mikrosekunden).

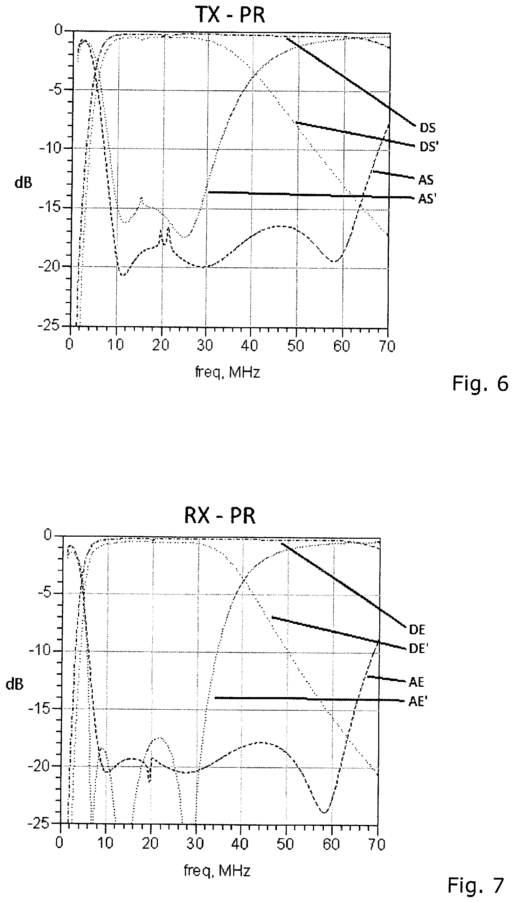

In **Fig. 6** ist der simulierte Verlauf der Dämpfung des Sendesignals **DS, DS'** und der Anpassung **AS, AS'** in Abhängigkeit von der Sendefrequenz für den erfindungsgemäßen Interface-Schaltkreis 6' und einen Interface-Schaltkreis gemäß dem Stand der Technik grafisch dargestellt. Die mit AS, DS bezeichneten Kurven (gestrichpunktet bzw. gestrichelt) beziehen sich dabei auf den erfindungsgemäßen Interface-Schaltkreis 6', die mit AS' und DS' bezeichneten Kurven (gepunktet) auf den Interface-Schaltkreis gemäß dem Stand der Technik. Hierbei ist zu erkennen, dass bei der erfindungsgemäßen Schaltung im Sendefall ein deutlich größerer Frequenzbereich im Vergleich zum Stand der Technik zur Verfügung steht. Die Simulation der erfindungsgemäßen Schaltung und der aus dem Stand der Technik bekannten Schaltung hat gezeigt, dass die Rückflussdämpfung, also die Abweichung von der Sollimpedanz, meist 50 Ohm, bei der erfindungsgemäßen Anordnung ein deutlich breiteres Frequenzfenster von 8-63 MHz (Frequenzverhältnis 7,8) im Vergleich zum Stand der Technik mit 10-28 MHz (Frequenzverhältnis 2,8) erlaubt, bezogen auf eine Dämpfung von 15 dB. Durch andere Dimensionierung der relevanten HF-Bauteile können auch andere Frequenzbereiche mit einem gegenüber dem Stand der Technik größerem Frequenzverhältnis realisiert werden.

In **Fig. 7** ist der Verlauf der Dämpfung des Empfangssignals **DE, DE'** und der Anpassung **AE, AE'** in Abhängigkeit von der Frequenz des Empfangssignals für den erfindungsgemäßen Interface-Schaltkreis 6' und einen Interface-Schaltkreis gemäß dem Stand der Technik grafisch dargestellt. Die mit AE, DE bezeichneten Kurven (gestrichpunktet bzw. gestrichelt) beziehen sich dabei auf den erfindungsgemäßen Interface-Schaltkreis 6', die mit AE' und DE' bezeichneten Kurven (gepunktet) auf den Interface-Schaltkreis gemäß dem Stand der Technik. Auch hier ist zu erkennen, dass die erfindungsgemäße Schaltung ein deutlich breiteres Spektrum an Frequenzen passieren lässt als der aus dem Stand der Technik bekannte Interface-Schaltkreis. Insbesondere bei MR Anwendungen ist es vorteilhaft ein breites Frequenzspektrum zur Verfügung zu haben, da somit auf der Resonanzfrequenz mehrerer Atomkerne mit unterschiedlichen Anregungsfrequenzen mit ein und derselben Sende-Empfangsschaltung gemessen werden kann.

Bei dem erfindungsgemäßen Interface-Schaltkreis 6, 6' wird durch eine geschickte Zusammenschaltung von HF-Bauteilen und Schaltelementen im Empfangsfall ein breitbandiger, verlustarmer Signalweg zum Empfangssystem 7 (z.B. einem Vorverstärker) zur Verfügung gestellt, während im Sendefall eine breitbandige und verlustarme Sperre für die Sendeleistung zum Empfangssystem 7 realisiert wird. Der erfindungsgemäße Interface-Schaltkreis 6, 6' bietet daher trotz eines einfachen Aufbaus einen großen nutzbaren Frequenzbereich.

### Bezugszeichenliste

- 1: Magnetresonanzapparatur
- 2: Hauptmagnet
- 3: Gradientensystem
- 4: HF-Anordnung
- 5: HF-Generator
- 6, 6': Interface-Schaltkreis
- 7: Empfangssystem
- 8: Steuereinrichtung
- 9: Gradientenverstärker
- AE, AE': Anpassung des Empfangspfads
- AS, AS': Anpassung des Sendepfads
- C1-C7: kapazitive Elemente
- DS, DS': Dämpfung des Sendesignals
- DE, DE: Dämpfung des Empfangssignals
- EP: Empfangspfad
- K1: erster Schaltkreis des Empfangspfads
- K2: zweiter Schaltkreis des Empfangspfads
- L1-L4: induktive Elemente
- PR: Anschluss für die HF-Anordnung
- RX: Ausgang des Interface-Schaltkreises zum Empfangssystem
- S1-S4: Schaltelemente
- SP: Sendepfad
- TX: Eingang des Interface-Schaltkreises

## Patentansprüche

1. Hochfrequenz-Interface-Schaltkreis (6, 6') zum Leiten von Sendesignalen eines HF-Generators (5) über einen Eingang (TX) des Hochfrequenz-Interface-Schaltkreises (6, 6') zu einem Anschluss (PR) für eine HF-Anordnung (4) in einem Sendebetrieb und zum Leiten von Empfangssignalen von dem Anschluss (PR) der HF-Anordnung (4) über einen Ausgang (RX) des Hochfrequenz-Interface-Schaltkreises (6, 6') zu einem Empfangssystem (7) in einem Empfangsbetrieb, wobei der Interface-Schaltkreis (6, 6') Folgendes umfasst:
einen Sendepfad (SP), der den Eingang (TX) des Hochfrequenz-Interface-Schaltkreises (6, 6') mit dem Anschluss (PR) verbindet;
einen Empfangspfad (EP), der den Anschluss (PR) mit dem Ausgang (RX) des Hochfrequenz-Interface-Schaltkreises (6, 6') verbindet, wobei der Empfangspfad (EP) einen ersten Schaltkreis (K1) umfasst,
wobei der erste Schaltkreis (K1) mindestens ein erstes Schaltelement (S1) umfasst, welches im Sendebetrieb elektrisch leitend und im Empfangsbetrieb elektrisch isolierend ist,
wobei im Sendebetrieb der erste Schaltkreis (K1) zwei in Serie geschaltete Parallelresonanzkreise bildet, die den Ausgang (RX) des Hochfrequenz-Interface-Schaltkreises (6, 6') von dem Anschluss (PR) isolieren;
**dadurch gekennzeichnet,**
**dass** im Empfangsbetrieb der erste Schaltkreis (K1) zwei parallel geschaltete Serienresonanzkreise umfasst.

2. Hochfrequenz-Interface-Schaltkreis (6, 6') nach Anspruch 1, **dadurch gekennzeichnet,**
**dass** der erste Schaltkreis (K1) ein erstes induktives Element (L1), ein zweites induktives Element (L2), ein erstes kapazitives Element (C1) und ein zweites kapazitives Element (C2) umfasst,
**dass** im Sendefall das zweite kapazitive Element (C2) zusammen mit dem ersten induktiven Element (L1) und das erste kapazitive Element (C1) zusammen mit dem zweiten induktiven Element (L2) jeweils einen der beiden Parallelresonanzkreise des ersten Schaltkreises (K1) bilden und dass das erste Schaltelement (S1) Teil sowohl des ersten als auch des zweiten Parallelresonanzkreises ist, und
**dass** im Empfangsfall das zweite kapazitive Element (C2) zusammen mit dem zweiten induktiven Element (L2) und das erste kapazitive Element (C1) zusammen mit dem ersten induktiven Element (L1) jeweils einen der beiden Serienresonanzkreise des ersten Schaltkreises (K1) bilden.

3. Hochfrequenz-Interface-Schaltkreis (6, 6') nach einem der vorherigen Ansprüche, **dadurch gekennzeichnet, dass** der Empfangspfad (EP) ein erdendes zweites Schaltelement (S2) umfasst, welches im Sendebetrieb elektrisch leitend und im Empfangsbetrieb elektrisch isolierend ist.

4. Hochfrequenz-Interface-Schaltkreis (6, 6') nach Anspruch 3, **dadurch gekennzeichnet, dass** das zweite Schaltelement (S2) im Empfangspfad (EP) direkt vor dem Ausgang (RX) des Hochfrequenz-Interface-Schaltkreises (6, 6') angeordnet ist.

5. Hochfrequenz-Interface-Schaltkreis (6') nach Anspruch 3 oder 4, **dadurch gekennzeichnet, dass** der Empfangspfad (EP) einen zweiten Schaltkreis (K2) umfasst, der in Serie zum ersten Schaltkreis (K1) geschaltet ist, wobei das zweite Schaltelement (S2) Teil des zweiten Schaltkreises (K2) ist , und wobei der zweite Schaltkreis (K2) im Empfangsbetrieb einen Tiefpass und im Sendebetrieb einen dritten Parallelresonanzkreis bildet.

6. Hochfrequenz-Interface-Schaltkreis (6') nach Anspruch 5, **dadurch gekennzeichnet, dass** der zweite Schaltkreis (K2) ein drittes induktives Element (L3), und ein drittes kapazitives Element (C3) umfasst, welche zusammen im Sendebetrieb Teil des dritten Parallelresonanzkreises und im Empfangsbetrieb Teil des Tiefpasses sind.

7. Hochfrequenz-Interface-Schaltkreis (6') nach Anspruch 5 oder 6, **dadurch gekennzeichnet, dass** der zweite Schaltkreis (K2) zusätzlich ein viertes kapazitives Element (C4) und ein erdendes drittes Schaltelement (S3) umfasst, welches im Sendebetrieb elektrisch leitend und im Empfangsbetrieb elektrisch isolierend ist, wobei im Sendebetrieb das vierte kapazitive Element (C4) Teil des dritten Parallelresonanzkreises ist.

8. Hochfrequenz-Interface-Schaltkreis (6') nach einem der Ansprüche 5 bis 7, **dadurch gekennzeichnet, dass** der zweite Schaltkreis (K2) zusätzlich ein fünftes kapazitives Element (C5) umfasst, welches parallel zum zweiten Schaltelement (S2) liegt und im Empfangsbetrieb Teil des Tiefpasses ist.

9. Hochfrequenz-Interface-Schaltkreis (6') nach einem der Ansprüche 6 bis 8, **dadurch gekennzeichnet, dass** die Induktivität des dritten induktiven Elementes (L3) halb so groß ist wie die Induktivität des ersten induktiven Elementes (L1) oder des zweiten induktiven Elementes (L2).

10. Hochfrequenz-Interface-Schaltkreis (6, 6') nach einem der vorherigen Ansprüche, **dadurch gekennzeichnet, dass** der Sendepfad (SP) einen Eingangs-Isolationsschaltkreis umfasst mit einem vierten Schaltelement (S4), welches im Sendebetrieb elektrisch leitend und im Empfangsbetrieb elektrisch isolierend ist.

11. Hochfrequenz-Interface-Schaltkreis (6, 6') nach Anspruch 10, **dadurch gekennzeichnet, dass** der Eingangs-Isolationsschaltkreis im Sendebetrieb ein HF-Filter ist.

12. Hochfrequenz-System mit einem HF-Generators (5) zum Erzeugen von HF-Signalen, einer HF-Anordnung (4) zum Senden und Detektieren von HF-Signalen, ein Empfangssystem (7) zum Verarbeiten der detektierten HF-Signale und einem Hochfrequenz-Interface-Schaltkreis (6, 6') nach einem der vorhergehenden Ansprüche, wobei der HF-Generator am Eingang (TX) des Hochfrequenz-Interface-Schaltkreises (6, 6'), das Empfangssystem (7) am Ausgang (RX) und die HF-Anordnung am Anschluss (PR) des Hochfrequenz-Interface-Schaltkreises (6, 6') angeschlossen sind.

13. Magnetresonanzapparatur (1) mit einer HF-Anordnung (4) zum Anregen von Magnetresonanzen und zum Empfangen von MR-Signalen und mit einem Hochfrequenz-Interface-Schaltkreis (6, 6') gemäß einem der Ansprüche 1 bis 11.

14. Magnetresonanzapparatur (1) nach Anspruch 13, **dadurch gekennzeichnet, dass** es sich bei der HF-Anordnung (4) um einen MR-Probenkopf handelt.

15. Verwendung eines Hochfrequenz-Interface-Schaltkreises (6, 6') gemäß einem der Ansprüche 1 bis 11 in einer Magnetresonanzapparatur (1).

## Claims

1. A high-frequency interface circuit (6, 6') to direct signals transmitted by an HF generator (5) to a connector (PR) for an HF set-up (4) in a transmit mode via an input (TX) of the high-frequency interface circuit (6, 6') and to direct received signals from the connector (PR) of the HF set-up (4) to a receiver system (7) in a receive mode via an output (RX) of the high-frequency interface circuit (6, 6'), wherein the interface circuit (6, 6') comprises the following:
a transmit path (SP) that links the input (TX) of the high-frequency interface circuit (6, 6') to the connector (PR);
a receive path (EP) that links the connector (PR) to the output (RX) of the high-frequency interface circuit (6, 6'), wherein the receive path (EP) includes a first circuit (K1),
wherein the first circuit (K1) includes at least a first switching element (S1) that is electroconductive in transmit mode and electrically insulating in receive mode,
wherein, in transmit mode, the first circuit (K1) forms two parallel resonance circuits connected in series that insulate the output (RX) of the high-frequency interface circuit (6, 6') from the connector (PR);
**characterized in that**
in receive mode, the first circuit (K1) includes two series resonance circuits connected in parallel.

2. The high-frequency interface circuit (6, 6') as claimed in claim 1, **characterized in that**
the first circuit (K1) comprises a first inductive element (L1), a second inductive element (L2), a first capacitive element (C1) and a second capacitive element (C2),
in the case of transmission, the second capacitive element (C2) together with the first inductive element (L1) and the first capacitive element (C1) together with the second inductive element (L2) each form one of the two parallel resonance circuits of the first circuit (K1) and
the first switching element (S1) is part of both the first as well as the second parallel resonance circuit and
in the case of receiving, the second capacitive element (C2) together with the second inductive element (L2) and the first capacitive element (C1) together with the first inductive element (L1) each form one of the two series resonance circuits of the first circuit (K1).

3. The high-frequency interface circuit (6, 6') as claimed in one of the previous claims, **characterized in that** the receive path (EP) includes a second grounding switching element (S2) that is electroconductive in transmit mode and electrically insulating in receive mode.

4. The high-frequency interface circuit (6, 6') as claimed in claim 3, **characterized in that** the second switching element (S2) in the receive path (EP) is positioned directly before the output (RX) of the high-frequency interface circuit (6, 6').

5. The high-frequency interface circuit (6') as claimed in claim 3 or 4, **characterized in that** the receive path (EP) includes a second circuit (K2) that is connected to the first circuit (K1) in series, wherein the second switching element (S2) is part of the second circuit (K2), and wherein the second circuit (K2) forms a low pass in receive mode and a third parallel resonance circuit in transmit mode.

6. The high-frequency interface circuit (6') as claimed in claim 5, **characterized in that** the second circuit (K2) includes a third inductive element (L3) and a third capacitive element (C3) that together form part of the third parallel resonance circuit in transmit mode and part of the low pass in receive mode.

7. The high-frequency interface circuit (6') as claimed in claim 5 or 6, **characterized in that** the second circuit (K2) additionally includes a fourth capacitive element (C4) and a third grounding switching element (S3) that is electroconductive in transmit mode and electrically insulating in receive mode, wherein, in transmit mode, the fourth capacitive element (C4) is part of the third parallel resonance circuit.

8. The high-frequency interface circuit (6') as claimed in one of claims 5 to 7, **characterized in that** the second circuit (K2) additionally includes a fifth capacitive element (C5) that is located parallel to the second switching element (S2) and is part of the low pass in receive mode.

9. The high-frequency interface circuit (6') as claimed in one of claims 6 to 8, **characterized in that** the inductance of the third inductive element (L3) is half as big as the inductance of the first inductive element (L1) or the second inductive element (L2).

10. The high-frequency interface circuit (6, 6') as claimed in one of the previous claims, **characterized in that** the transmit path (SP) includes an input-isolator circuit with a fourth switching element (S4) that is electroconductive in transmit mode and electrically insulating in receive mode.

11. The high-frequency interface circuit (6, 6') as claimed in claim 10, **characterized in that** the input-isolator circuit is an HF filter in transmit mode.

12. A high-frequency system with an HF generator (5) to generate HF signals, an HF set-up (4) to send and detect HF signals, a receiver system (7) to process the detected HF signals and a high-frequency interface circuit (6, 6') as claimed in any one of the previous claims, wherein the HF generator is connected to the input (TX) of the high-frequency interface circuit (6, 6'), the receiver system (7) is connected to the output (RX), and the HF set-up is connected to the connector (PR) of the high-frequency interface circuit (6, 6').

13. A magnetic resonance apparatus (1) with an HF set-up (4) to excite magnetic resonances and to receive MR signals and with a high-frequency interface circuit (6, 6') as claimed in one of the claims 1 to 11.

14. The magnetic resonance apparatus (1) as claimed in claim 13, **characterized in that** the HF set-up (4) is an MR probe.

15. The use of a high-frequency interface circuit (6, 6') as claimed in one of the claims 1 to 11 in a magnetic resonance apparatus (1).

## Revendications

1. Circuit d'interface haute fréquence (6, 6') pour amener des signaux d'émission d'un générateur HF (5) via une entrée (TX) du circuit d'interface haute fréquence (6, 6') à une borne (PR) pour un dispositif HF (4) dans un mode d'émission et pour amener des signaux de réception de la borne (PR) du dispositif HF (4) via une sortie (RX) du circuit d'interface haute fréquence (6, 6') à un système de réception (7) dans un mode de réception, le circuit d'interface (6, 6') comprenant :
une voie d'émission (SP) qui relie l'entrée (TX) du circuit d'interface haute fréquence (6, 6') à la borne (PR) ;
une voie de réception (EP) qui relie la borne (PR) à la sortie (RX) du circuit d'interface haute fréquence (6, 6'), le chemin de réception (EP) comprenant un premier circuit (K1),
le premier circuit (K1) comprenant au moins un premier élément de commutation (S1) qui est électriquement conducteur en mode d'émission et électriquement isolant en mode de réception,
le premier circuit (K1) formant, en mode d'émission, deux circuits résonants parallèles connectés en série qui isolent la sortie (RX) du circuit d'interface haute fréquence (6, 6') de la borne (PR) ;
**caractérisé en ce**
**qu'**en mode de réception, le premier circuit (K1) comprend deux circuits résonants série connectés en parallèle.

2. Circuit d'interface haute fréquence (6, 6') selon la revendication 1, **caractérisé en ce**
**que** le premier circuit (K1) comprend un premier élément inductif (L1), un deuxième élément inductif (L2), un premier élément capacitif (C1) et un deuxième élément capacitif (C2),
**que**, en cas d'émission, le deuxième élément capacitif (C2) forme avec le premier élément inductif (L1) et le premier élément capacitif (C1) forme avec le deuxième élément inductif (L2) respectivement l'un des deux circuits résonants parallèles du premier circuit (K1) et
**que** le premier élément de commutation (S1) fait partie à la fois du premier et du deuxième circuit résonant parallèle, et
**que**, en cas de réception, le deuxième élément capacitif (C2) forme avec le deuxième élément inductif (L2) et le premier élément capacitif (C1) forme avec le premier élément inductif (L1) respectivement l'un des deux circuits résonants série du premier circuit (K1).

3. Circuit d'interface haute fréquence (6, 6') selon l'une des revendications précédentes, **caractérisé en ce que** la voie de réception (EP) comprend un deuxième élément de commutation de mise à la terre (S2) qui est électriquement conducteur en mode d'émission et électriquement isolant en mode de réception.

4. Circuit d'interface haute fréquence (6, 6') selon la revendication 3, **caractérisé en ce que** le deuxième élément de commutation (S2) est disposé dans la voie de réception (EP) directement avant la sortie (RX) du circuit d'interface haute fréquence (6, 6').

5. Circuit d'interface haute fréquence (6') selon la revendication 3 ou 4, **caractérisé en ce que** la voie de réception (EP) comprend un deuxième circuit (K2) qui est connecté en série avec le premier circuit (K1), le deuxième élément de commutation (S2) faisant partie du deuxième circuit (K2) et le deuxième circuit (K2) formant un filtre passe-bas en mode de réception et un troisième circuit résonant parallèle en mode d'émission.

6. Circuit d'interface haute fréquence (6') selon la revendication 5, **caractérisé en ce que** le deuxième circuit (K2) comprend un troisième élément inductif (L3) et un troisième élément capacitif (C3) qui, ensemble, font partie du troisième circuit résonant parallèle en mode d'émission et partie du filtre passe-bas en mode de réception.

7. Circuit d'interface haute fréquence (6') selon la revendication 5 ou 6, **caractérisé en ce que** le deuxième circuit (K2) comprend en plus un quatrième élément capacitif (C4) et un troisième élément de commutation de mise à la terre (S3) qui est électriquement conducteur en mode d'émission et électriquement isolant en mode de réception, le quatrième élément capacitif (C4) faisant partie du troisième circuit résonant parallèle en mode d'émission.

8. Circuit d'interface haute fréquence (6') selon l'une des revendications 5 à 7, **caractérisé en ce que** le deuxième circuit (K2) comprend en plus un cinquième élément capacitif (C5) qui est en parallèle avec le deuxième élément de commutation (S2) et fait partie du filtre passe-bas en mode de réception.

9. Circuit d'interface haute fréquence (6') selon l'une des revendications 6 à 8, **caractérisé en ce que** l'inductance du troisième élément inductif (L3) est la moitié de l'inductance du premier élément inductif (L1) ou du deuxième élément inductif (L2).

10. Circuit d'interface haute fréquence (6, 6') selon l'une des revendications précédentes, **caractérisé en ce que** la voie d'émission (SP) comprend un circuit d'isolation d'entrée avec un quatrième élément de commutation (S4) qui est électriquement conducteur en mode d'émission et électriquement isolant en mode de réception.

11. Circuit d'interface haute fréquence (6, 6') selon la revendication 10, **caractérisé en ce que** le circuit d'isolation d'entrée est un filtre HF en mode d'émission.

12. Système haute fréquence comprenant un générateur HF (5) pour générer des signaux HF, un dispositif HF (4) pour émettre et détecter des signaux HF, un système de réception (7) pour traiter les signaux HF détectés et un circuit d'interface haute fréquence (6, 6') selon l'une des revendications précédentes, dans lequel le générateur HF est connecté à l'entrée (TX) du circuit d'interface haute fréquence (6, 6'), le système de réception (7) à la sortie (RX) et le dispositif HF à la borne (PR) du circuit d'interface haute fréquence (6, 6').

13. Appareil de résonance magnétique (1) comprenant un dispositif HF (4) pour exciter des résonances magnétiques et pour recevoir des signaux RM et comprenant un circuit d'interface haute fréquence (6, 6') selon l'une des revendications 1 à 11.

14. Appareil de résonance magnétique (1) selon la revendication 13, **caractérisé en ce que** le dispositif HF (4) est une tête de sonde RM.

15. Utilisation d'un circuit d'interface haute fréquence (6, 6') selon l'une des revendications 1 à 11 dans un appareil de résonance magnétique (1).
